# EUROPÄISCHE PATENTSCHRIFT

(11) **EP 1 430 313 B1**
(45) Veröffentlichungstag und Bekanntmachung des Hinweises auf die Patenterteilung: **22.12.2004**
(21) Anmeldenummer: 02772256.0
(22) Anmeldetag: 31.08.2002
(51) Int. Cl.: G01R 15/20, G01R 15/18

(54) **MESSWANDLER**
MEASURING TRANSFORMER
TRANSFORMATEUR DE MESURE

(30) Priorität: 14.09.2001 DE 10145415
(43) Veröffentlichungstag der Anmeldung: 23.06.2004
(73) Patentinhaber: Wobben, Aloys, 26607 Aurich (DE)
(72) Erfinder: Wobben, Aloys, 26607 Aurich (DE)
(74) Vertreter: Eisenführ, Speiser & Partner
(86) Internationale Anmeldenummer: PCT/EP2002/009748
(87) Internationale Veröffentlichungsnummer: WO 2003/025590

(56) Entgegenhaltungen:
- EP-A- 0 157 054
- EP-A- 0 194 225
- EP-A- 0 580 473
- OGASAWARA S ET AL: "A digital current sensor for PWM inverters" PROCEEDINGS OF THE INDUSTRY APPLICATIONS SOCIETY ANNUAL MEETING. HOUSTON, OCT. 4 - 9, 1992, NEW YORK, IEEE, US, Bd. 1, 4. Oktober 1992 (1992-10-04), Seiten 949-955, XP010063656 ISBN: 0-7803-0635-X

## Beschreibung

Die Erfindung betrifft einen Messwandler zum Vergleichen eines einen Leiter durchfließenden Stromes mit einem Sollstrom mit einem von einem Ringkem gebildeten Magnetkreis, mit einem von dem Ringkem umschlossenen stromdurchflossenen Leiter, mit einer auf dem Ringkern angeordneten Sekundärwicklung und mit einem in einem Spalt des Ringkerns angeordneten, für das Magnetfeld im Spalt empfindlichen Magnetfeldmesselement. Die Erfindung betrifft weiter eine Steuerungseinheit zur Steuerung oder Regelung eines einen Leiter durchfließenden Stromes, einen Wechselrichter, insbesondere für eine Windenergieanlage, sowie eine Windenergieanlage mit einem solchen Wechselrichter.

Ein Messwandler der eingangs genannten Art ist aus der EP 0 194 225 bekannt. Bei diesem Messwandler speist das verstärkte Ausgangssignal eines Hall-Elements, das als Magnetflussmesselement dient, die Sekundärwicklung. Deren Wickelsinn ist so gewählt, dass das entstehende Magnetfeld dem den stromdurchflossenen Leiter umgebenden Magnetfeld entgegengerichtet ist. Die Sekundärwicklung wird dabei von dem Verstärker derart gespeist, dass er das von dem Leiter hervorgerufene Magnetfeld zu Null zu machen sucht. Als Maß für den in dem Leiter fließenden Strom wird der Strom durch die Sekundärwicklung herangezogen, d.h., das Ausgangssignal der Sekundärwicklung gibt den Absolutwert des momentanen Stromflusses an.

Ein weiterer Messwandler der eingangs genannten Art ist aus elektronik industrie 8-2001, Seiten 49 und 51 bekannt. Auch bei diesem Messwandler ist wiederum eine Spule um den Ringkem herum gewickelt, in welche der durch den Leiter fließende Strom wiederum einen Strom induziert. Dieser induzierte Strom wird mit einer eventuellen, von dem Hall-Element erfassten Abweichung überlagert und gibt somit wiederum einen Absolutwert als Maß für den in dem Leiter fließenden Strom an. Auch bei diesem Messwandler muss allerdings wieder die Sekundärwicklung von dem Hauptanteil des induzierten Stromes durchflossen werden. Die Kombination aus Hall-Element und Verstärker erfasst jeweils den Anteil des in dem Leiter fließenden Stromes, den die Sekundärwicklung auf dem Ringkem nicht erfassen kann.

Ein Messwandler der eingangs genannten Art ist des weiteren auch aus der EP 0 580 473 A1 bekannt. Aus der EP 0 157 054 A ist ein Fehlerstromschutzschalter bekannt, bei dem zwei Windungen auf einem Ringkem angeordnet sind. Mittels eines Komparators wird die Ausgangsspannung eines in einem Zwischenraum des Ringkems angeordneten Hall-Elements mit einer Referenzspannung verglichen. Mittels der Ausgangsspannung des Komparators wird der Schalter. dann gesteuert.

Aus dem Artikel Ogasawara et al. "A Digital Current Sensor for PWM Inverters", Proceedings of the Industry Applications Society Annual Meeting, Houston, October 4, 1992, New York, US, Bd. 1, 4. Oktober 1992, Seiten 949-955 ist in Figur 2 ein weiterer Messwandler für analoge Ströme bekannt, der dem aus der EP 0 194 225 bekannten Messwandler in etwa entspricht.

Bei den bekannten Messwandlern kann das Ausgangssignal jeweils auf beliebige Weise weiter verarbeitet werden, da es den Absolutwert des momentanen Stromflusses durch den Leiter angibt Ober einen nachgeschalteten Komparator kann dieser Wert z.B. mit einem Sollwert verglichen werden, um daraus Steuerungssignale z.B. für einen Wechselrichter, abzuleiten, dessen Strom Ober den genannten Leiter abgegeben wird. Da dieser Strom ohne weiteres einige hundert Ampere - Spitzen-Momentanwerte erreichen durchaus ca. 750 Ampere - betragen kann, muss mit der Sekundärwicklung eine entsprechend hohe Amperewindungszahl erreicht werden. Je geringer dabei der durch die Sekundärwicklung fließende Strom sein soll, desto höher muss entsprechend die Windungszahl sein.

Darin liegt jedoch auch der wesentliche Nachteil der bekannten Lösungen. Eine Induktivität bildet stets auch eine Zeitkonstante und begrenzt damit die Möglichkeiten, Schwankungen des in dem Leiter fließenden Stromes schnell - zu folgen. Erschwerend kommt außerdem hinzu, dass die Induktivität der Sekundärwicklung selbst durch ihr typisch induktives Verhalten schnelle Signaländerungen unmöglich macht.

Der Erfindung liegt daher die Aufgabe zugrunde, einen hinsichtlich der genannten Nachteile verbesserten Messwandler anzugeben, mit dem insbesondere auch hochfrequente Abweichungen von einem Sollwert sicher erfasst werden können und der sich insbesondere bei einem Wechselrichter für eine Windenergieanlage einsetzen lässt.

Diese Aufgabe wird erfindungsgemäß dadurch gelöst, dass eine. Sollvorgabeeinheit vorgesehen ist zur Beaufschlagung der Sekundärwicklung mit einem Sollstrom, welcher den Strom vorgibt, der in dem von dem stromdurchflossenen Leiter fließen soll.

Anders als bei den bekannten Lösungen ist die Sekundärwicklung nicht mit dem Ausgang des Magnetflussmesselements oder einem daran angeschlossenen Verstärker verbunden. Statt dessen wird ein Sollstrom eingespeist Der Ausgang des Magnetflussmesselements bzw. eines in einer bevorzugten Ausgestaltung daran angeschlossenen Verstärkers steht erfindungsgemäß als Signalausgang zur Verfügung. Im Idealfall entspricht der in dem Leiter fließende Strom dem in die Sekundärwicklung eingespeisten Sollstrom, so dass der resultierende magnetische Fluss in dem Ringkem und das Signal am Ausgang des Magnetflussmesselements null sind.

Wenn der Strom in dem Leiter von dem Sollwert abweicht, ergeben sich ein resultierender magnetischer Fluss in dem Ringkem und ein entsprechendes Signal am Ausgang des Magnetflussmesselements. Dieses Signal ist ein Maß für die Abweichung des Stromes in dem Leiter von dem die Sekundärwicklung durchfließenden Sollwert des Stromes. Da in dem Ausgangszweig zwischen Magnetflussmesselement und Signalausgang keine Induktivität vorhanden ist, können auch hochfrequente Abweichungen vom Sollwert des Stromes sicher erfasst, gegebenenfalls verstärkt und am Ausgang bereitgestellt werden. Dementsprechend können auch schnell entsprechende Steuerungs- bzw. Regelungssignale für einen Wechselrichter, beispielsweise einer Windenergieanlage, aus dem Ausgangssignal abgeleitet werden, um den Istwert dem Sollwert des Stromes schnellst- und bestmöglich anzunähern.

Vorteilhafte Ausgestaltungen des erfindungsgemäßen Messwandlers ergeben sich aus den Unteransprüchen. Bevorzugt wird als Magnetflussmess-element ein Hall-Element eingesetzt. Außerdem wird das Ausgangssignal des Magnetflussmesselements vorzugsweise von einem Verstärker verstärkt, bevor es am Signalausgang zur Verfügung gestellt wird.

Um den Absolutwert des in dem Leiter fließenden Stromes zu erhalten, kann der Sollstrom mit dem Ausgangssignal des Magnetflussmessefementes bzw. des nachgeschalteten Verstärkers überlagert werden, was bevorzugt in einer dem Signalausgang nachgeschalteten Stufe erfolgt.

Die Erfindung betrifft auch eine Steuerungseinheit gemäß Anspruch 6 zur Steuerung oder Regelung eines einen Leiter durchfließenden Stromes mit einem erfindungsgemäßen Messwandler zur Messung des den Leiter durchfließenden Stromes. Bevorzugt wird der erfindungsgemäße Messwandler bei einem Wechselrichter für eine Windenergieanlage zur Messung des Ausgangsstromes des Wechselrichters eingesetzt. Demgemäss betrifft die Erfindung auch eine Windenergieanlage gemäß Anspruch 9.

Die Erfindung wird nachfolgend anhand der Zeichnungen näher erläutert. Es zeigen:
- Fig. 1: eine schematische Darstellung eines bekannten Messwandlers; und
- Fig. 2: eine schematische Darstellung eines erfindungsgemäßen Messwandlers.

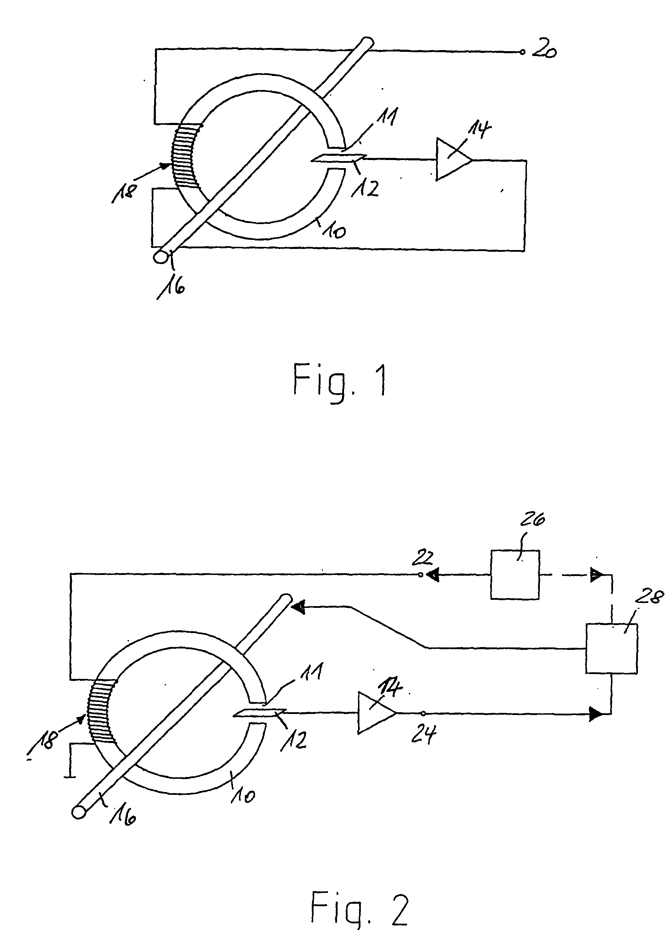

In Figur 1 ist das bei dem aus der EP 0 194 225 bekannten Messwandler verwendete Prinzip vereinfacht dargestellt. Bei diesem Messwandler ist zunächst ein Ringkem 10 aus ferromagnetischem Material vorgesehen, durch den ein von dem zu messenden Strom durchflossener Leiter 16 verläuft. In dem Luftspalt 11 des Ringkems 10 ist ein Hall-Element 12 angeordnet. Das durch den Stromfluss um den Leiter 16 herum ausgebildete Magnetfeld führt zu einem magnetischen Fluss in dem Ringkem 10 und damit auch durch das Hall-Element 12. Das Ausgangssignal des Hall-Elements 12 wird einem Verstärker 14 zugeführt, dessen Ausgang an eine Sekundärwicklung 18 angeschlossen ist, die um den Ringkern 10 herum gewickelt ist.

Wird die Sekundärwicklung 18 nun von einem Strom durchflossen, bildet diese ebenfalls ein Magnetfeld aus. Dabei ist der Wickelsinn der Sekundärwicklung 18 so gewählt, dass das entsprechende Magnetfeld dem den Leiter 16 umschließenden Magnetfeld entgegengerichtet ist. Daraus ergibt sich, dass sich beide Magnetfelder aufheben, dass also in dem Ringkem 10 kein magnetischer Fluss mehr auftritt und folglich das Hall-Element 12 kein Signal mehr erzeugt, wenn beide Magnetfelder gleich groß sind. Da die Sekundärwicklung 18 bekannt ist, ist der hindurchfließende Strom ein Maß für das von dem Leiter 16 erzeugte Magnetfeld und damit ein Maß für den in dem Leiter 16 flieβenden Strom. Somit kann an dem Ausgang 20 der Sekundärwicklung 18 ein Signal erfasst werden, das ein Maß für den in dem Leiter 16 fließenden Strom ist.

Dieses Ausgangssignal am Ausgang 20 kann auf beliebige Weise weiterverarbeitet werden, da es den Absolutwert des momentanen Stromflusses angibt. Über einen (nicht gezeigten) nachgeschalteten Komparator kann dieser Wert z.B. mit einem Sollwert verglichen werden, um daraus beispielsweise Steuerungssignale für einen Wechselrichter abzuleiten, dessen Strom über den Leiter 16 abgegeben wird.

Da ein solcher Strom ohne weiteres einige hundert Ampere betragen kann, muss mit der Sekundärwicklung 18 eine entsprechend hohe Amperewindungszahl erreicht werden. Je geringer dabei der durch die Sekundärwicklung 18 fließende Strom sein soll, desto höher muss entsprechend die Windungszahl sein. Darin liegt auch der wesentliche Nachteil dieser Lösung, denn eine Induktivität bildet stets auch eine Zeitkonstante und begrenzt damit die Möglichkeiten, hochfrequenten Schwankungen des in dem Leiter 16 fließenden Stromes schnell zu folgen. Erschwerend kommt außerdem hinzu, dass die Induktivität der Sekundärwicklung 18 selbst durch ihr typisch induktives Verhalten schnelle Signaländerungen unmöglich macht.

Eine Ausgestaltung eines erfindungsgemäßen Messwandlers ist schematisch in Figur 2 dargestellt. Dieser weist erneut einen Ringkem 10 aus einem ferromagnetischem Material mit einem Luftspalt 11, in dem ein Magnetflussmesselement 12, beispielsweise wiederum ein Hall-Element, angeordnet ist auf. Dem Hall-Element 12 ist ein Verstärker 14 nachgeschaltet zur Verstärkung des elektrischen Ausgangssignals des Hall-Elements 12. Wie bei dem bekannten Messwandier verläuft ein Leiter 16 durch den Ringkem 10, der von dem zu messenden Strom durchflossen wird.

Abweichend von dem bekannten Messwandler ist die Sekundärwicklung 18 nicht mit dem Ausgang des Verstärkers 14 verbunden. Stattdessen weist die Sekundärwicklung 18 einen Eingangsanschluss 22 auf und ist mit ihrem anderen Ende an Masse angeschlossen. Der Ausgang des Verstärkers 14 steht als Signalausgang 24 zur Verfügung.

Während also bei dem bekannten Messwandler die Sekundärwicklung 18 stets mit einem Strom beaufschlagt wird, der das Magnetfeld des Leiters 16 zu kompensieren sucht und somit ein Maß für den in dem Leiter 16 fließenden Strom bildet, wird die Sekundärwicklung 18 erfindungsgemäß mit einem vorgegebenen Sollstrom beaufschlagt. Dieser wird von einer Sollvorgabeeinheit 26 an den Eingangsanschluss 22 angelegt. Im Idealfall entspricht der in dem Leiter 16 fließende Strom diesem Sollstrom, so dass der resultierende magnetische Fluss in dem. Ringkem 10 gleich null ist, das Signal des Hall-Elements 12 null ist und sich somit auch am Ausgang 24 kein Signal ergibt.

Wenn der Strom in dem Leiter 16 von dem Sollwert abweicht, ergibt sich ein resultierender magnetischer Fluss in dem Ringkem 10 und ein entsprechendes Signal des Hall-Elementes 12, das über den Verstärker 14 verstärkt zum Ausgang 24 geführt ist. Dieses Ausgangssignal ist ein Maß für die Abweichung des Stromes in dem Leiter 16 von dem die Sekundärwicklung 18 durchfließenden Sollwert des Stromes.

Bei der Anwendung des erfindungsgemäßen Messwandlers zur Messung des Ausgangsstromes eines Wechselrichters, also des den Leiter 16 durchfließenden Stromes, hat der Sollstrom eine Frequenz von 50 Hz. Dies führt zu einer recht langsamen Änderung des Stromes in der Sekundärwicklung 18. Insofern spielt also die Induktivität der Sekundärwicklung 18 eine untergeordnete Rolle.

Schwankungen des Stromes in dem Leiter 16 können allerdings durch externe Einflüsse wie Netzrückwirkungen durchaus hochfrequent sein. Da erfindungsgemäß aber in dem Zweig bestehend aus Hall-Element 12, Verstärker 14 und Ausgang 24 keine Induktivität vorhanden ist, können auch hochfrequente Abweichungen vom Sollwert sicher erfasst, verstärkt und am Ausgang 24 bereitgestellt werden. Dementsprechend können auch schnell entsprechende Steuerungs- bzw. Regelungssignale für einen (nicht gezeigten) Wechselrichter aus dem Signal am Ausgang 24 mittels einer Steuerungseinheit 28 abgeleitet werden, um den Istwert dem Sollwert schnellstmöglich anzunähern.

Anders als bei der bekannten Lösung, bei der dem Messwandler ein Komparator nachgeschaltet werden muss, um einen Soll-Ist-Vergleich zu ermöglichen, wird dieser Vergleich bei der erfindungsgemäßen Lösung bereits in dem Messwandler mit vorgenommen. Der Ringkem 10 kann hier zusammen mit dem Hall-Element 12 als Komparator angesehen werden, da das Hall-Element 12 nur noch ein Differenzsignal zwischen Soll- und Ist-Wert liefert.

Es ist natürlich ohne weiteres möglich, das Differenzsignal am Ausgang 24 der erfindungsgemäßen Schaltung entweder als analoges Signal weiterzuverarbeiten oder beispielsweise über einen Schmitt-Trigger in digitale Steuerungssignale für den Wechselrichter umzuwandeln.

Ein Maß für den Absolutwert des in dem Leiter 16 fließenden Stromes wird bei dem erfindungsgemäßen Messwandler erhalten, wenn das Soll-Signal mit dem Ausgangssignal des Verstärkers 14 überlagert wird. Dieses überlagerte Signal wird jedoch nicht in die Sekundärwicklung 18 eingespeist. Diese Überlagerung wird vorzugsweise durch Summenbildung in einer dem Verstärker 14 nachgeschalteten Stufe erfolgen.

Der erfindungsgemäße Messwandler wird bevorzugt bei einer Windenergieanlage zur Messung des Ausgangsstroms des Wechselrichters eingesetzt, wobei bevorzugt für jede Phase des Wechselrichters ein separater Messwandlers eingesetzt wird.

## Patentansprüche

1. Messwandler zum Vergleichen eines einen Leiter (16) durchfließenden Stromes mit einem Sollstrom, mit einem von einem Ringkem (10) gebildeten Magnetkreis, mit einem von dem Ringkem (10) umschlossenen stromdurchflossenen Leiter (16), mit einer auf dem Ringkem (10) angeordneten Sekundärwicklung (18) und mit einem in einem Spalt des Ringkems (10) angeordneten, für das Magnetfeld im Spalt empfindlichen Magnetflussinesselement (12),
wobei eine Sollvorgabeeinheit (26) vorgesehen ist zur Beaufschlagung der Sekundärwicklung (18) mit einem vordefinierten Sollstrom, welcher den Strom vorgibt, der in dem von dem Strom durchflossenen Leiter (16) fließen soll,
und wobei das Magnetflussmesselement (12) zur Ausgabe eines die Differenz zwischen Sollstrom und den Leiter (16) durchfließenden Strom repräsentierenden Differenzsignals ausgestaltet ist.

2. Messwandler nach Anspruch 1,
**dadurch gekennzeichnet, dass** das Magnetflussmesselement (12) ein Hall-Element ist.

3. Messwandler nach einem der vorhergehenden Ansprüche,
**dadurch gekennzeichnet, dass** dem Ausgang des Magnetflussmesselements (12) ein Verstärker (14) zur Verstärkung des elektrischen Ausgangssignals des Magnetflussmesselements (12) nachgeschaltet ist.

4. Messwandier nach einem der vorhergehenden Ansprüche,
**dadurch gekennzeichnet, dass** eine Steuerungs- oder Regelungseinheit (28) zur Steuerung oder Regelung des den Leiter (16) durchfließenden Stromes vorgesehen ist derart, dass sich der den Leiter (16) durchfließende Strom dem Sollstrom annähert.

5. Messwandier nach einem der vorhergehenden Ansprüche,
**dadurch gekennzeichnet, dass** zur Bildung des Absolutwerts des zu messenden Stromes dem Magnetflussmesselement (12) Mittel nachgeschaltet sind zur Überlagerung des Sottstromes mit dem Ausgangssignal des Magnetflussmesselements (12).

6. Steuerungseinheit zur Steuerung oder Regelung eines einen (16) Leiter durchfließenden Stromes mit einem Messwandler nach einem der vorhergehenden Ansprüche zur Messung des den Leiter (16) durchfließenden Stromes.

7. Wechselrichter, insbesondere für eine Windenergieanlage, mit einer Steuerungseinheit nach Anspruch 6 zur Steuerung des Ausgangsstromes des Wechselrichters.

8. Wechselrichter nach Anspruch 7,
**dadurch gekennzeichnet, dass** die Sollvorgabeeinheit (26) Bestandteil des Wechselrichters ist.

9. Windenergieanlage mit einem Wechselrichter nach Anspruch 7 oder 8.

## Claims

1. A measuring transducer for comparing a current flowing through a conductor (16) with a reference current, comprising a magnetic circuit formed by a toroidal core (10), a conductor (16) through which the current flows and which is enclosed by the toroidal core (10), a secondary winding (18) arranged on the toroidal core (10), and a magnetic field measuring element (12) which is arranged in a gap in the toroidal core (10) and is sensitive to the magnetic field in the gap,
wherein a reference presetting unit (26) is provided for acting on the secondary winding (18) with a predefined reference current which presets the current which is intended to flow in the conductor (16) through which current flows and wherein the magnetic flux measuring element (12) is designed to emit a difference signal which represents the difference between the reference current and the current flowing through the conductor (16).

2. A measuring transducer according to Claim 1, **characterized in that** the magnetic flux measuring element (12) is a Hall element.

3. A measuring transducer according to one of the preceding claims, **characterized in that** the output of the magnetic flux measuring element (12) is followed by an amplifier (14) for amplifying the electrical output signal from the magnetic flux measuring element (12).

4. A measuring transducer according to one of the preceding claims, **characterized in that** a control or regulating unit (28) is provided for controlling or regulating the current flowing through the conductor (16), in such a way that the current flowing through the conductor (16) approximates to the reference current.

5. A measuring transducer according to one of the preceding claims, **characterized in that**, in order to form the absolute value of the current to be measured, means are connected downstream of the magnetic flux measuring element (12) in order to superimpose the output signal from the magnetic flux measuring element (12) on the reference current.

6. A control unit for controlling or regulating a current flowing through a conductor (16), having a measuring transducer according to one of the preceding claims for measuring the current flowing through the conductor (16).

7. An inverter, in particular for a wind energy installation, having a control unit according to Claim 6 for controlling the output current from the inverter.

8. An inverter according to Claim 7, **characterized in that** the reference presetting unit (26) is a component of the inverter.

9. A wind energy installation having an inverter according to Claim 7 or Claim 8.

## Revendications

1. Transformateur de mesure pour la comparaison d'un courant traversant un conducteur (16) à un courant de consigne, avec un circuit magnétique formé par un noyau annulaire (10), avec un conducteur (16) traversé par un courant entouré par le noyau annulaire (10), avec un enroulement secondaire (18) disposé sur le noyau annulaire (10) et avec un élément de mesure du flux magnétique (12) disposé dans une fente du noyau annulaire (10), élément de mesure sensible au champ magnétique dans la fente,
dans lequel est prévue une unité d'allocation de valeur de consigne (26) pour la sollicitation de l'enroulement secondaire (18) par un courant de consigne prédéfini, lequel définit le courant qui doit s'écouler dans le conducteur (16) parcouru par le courant,
et dans lequel l'élément de mesure du flux magnétique (12) est configuré pour délivrer un signal différentiel représentant la différence entre le courant de consigne et le courant traversant le conducteur (16).

2. Transformateur de mesure selon la revendication 1,
**caractérisé en ce que** l'élément de mesure du flux magnétique (12) est un élément de Hall.

3. Transformateur de mesure selon l'une quelconque des revendications précédentes,
**caractérisé en ce qu'**à la sortie de l'élément de mesure du flux magnétique (12) est branché en aval un amplificateur (14) pour l'amplification du signal électrique de sortie de l'élément de mesure du flux magnétique (12).

4. Transformateur de mesure selon l'une quelconque des revendications précédentes,
**caractérisé en ce qu'**une unité de commande ou de régulation (28) est prévue pour la commande ou pour la régulation du courant traversant le conducteur (16), de telle sorte que le courant traversant le conducteur (16) se rapproche du courant de consigne.

5. Transformateur de mesure selon l'une quelconque des revendications précédentes,
**caractérisé en ce que**, pour la formation de la valeur absolue du courant à mesurer, des moyens pour la superposition du courant de consigne par le signal de sortie de l'élément de mesure du flux magnétique (12) sont branchés en aval de l'élément de mesure du flux magnétique (12).

6. Unité de commande pour la commande ou pour la régulation d'un courant traversant un conducteur (16) avec un transformateur de mesure selon l'une quelconque des revendications précédentes pour la mesure du courant traversant le conducteur (16).

7. Onduleur, en particulier pour une installation éolienne de production d'énergie, avec une unité de commande selon la revendication 6 pour la commande du courant de sortie de l'onduleur.

8. Onduleur selon la revendication 7,
**caractérisé en ce que** l'unité d'allocation de valeur de consigne (26) fait partie de l'onduleur.

9. Installation éolienne de production d'énergie avec un onduleur d'après la revendication 7 ou 8.
